Europäisches Patentamt

European Patent Office

Office européen des brevets

(19)

(11) Publication number: **0 150 564**
**A2**

# (12) EUROPEAN PATENT APPLICATION

(21) Application number: **84307100.2**

(22) Date of filing: **17.10.84**

(51) Int. Cl.⁴: **H 01 L 31/10**

(30) Priority: **26.10.83 US 545945**

(43) Date of publication of application: **07.08.85**
**Bulletin 85/32**

(84) Designated Contracting States: **BE DE FR GB IT NL SE**

(71) Applicant: **AMERICAN TELEPHONE AND TELEGRAPH COMPANY, 550 Madison Avenue, New York, NY 10022 (US)**

(72) Inventor: **Capasso, Federico, 205 Ayliffe Avenue, Westfield New Jersey 07090 (US)**
Inventor: **Cho, Alfred Yi, 11 Kenneth Court, Summit New Jersey 07901 (US)**

(74) Representative: **Buckley, Christopher Simon Thirsk et al, Western Electric Company Limited 5 Mornington Road, Woodford Green Essex IG8 OTU (GB)**

(54) Electronic device comprising a heterojunction.

(57) This invention relates to heterojunction photodetectors and especially an avalanche photodetector having separate absorption (31) and multiplication (21) regions together with low dark current and high sensitivity.

EP 0 150 564 A2

ACTORUM AG

IMPROVEMENTS IN OR RELATING TO ELECTRONIC DEVICES

This invention relates to electronic devices and finds application, for example, in heterojunction photodetectors.

There is great interest at the present time, as there has been for a period of time, in photodetectors that have characteristics such as rapid response times and low noise. While such photodetectors have many possible applications, one application of special interest today is in optical communications systems. Such systems, as presently contemplated, have a light source and a photodetector optically coupled to each other by a glass transmission line which is commonly called an optical fiber.

Accordingly, several approaches have been taken in attempting to fabricate phodetectors having such characteristics for applications in optical communications systems. One type of phodetector of special interest for use in optical communications systems because of the possibilities it affords of having such characteristics is the avalanche photodetector (APD). Avalanche photodetectors exhibit current gain because of avalanche multiplication initiated by at least one type of carrier. An early example of such a photodetector is described in IEEE Transactions on Electron Devices, ED-14, pp.239-251, May 1967. The silicon structure described has a p+-i-p-n+ doping profile and was termed a reach-through avalanche photodetector (RAPD) because the electric field extended from the n+-p avalanche region on one side of the device through an intrinsic region to the p+ layer which functioned as an ohmic contact on the other side of the device. The doping profile was similar to that of a Read diode or that of an IMPATT diode.

While the first avalanche photodetectors brought to a high degree of perfection used elemental semiconductors such as silicon or germanium, avalanche photodetectors have also been proposed using numerous other semiconductors including various Group III-V compound semiconductors. Interest in APDs using such semiconductors has increased as interest in optical communications systems has shifted from those using wavelengths near 0.8 μm to those using longer wavelengths, particularly wavelengths in the region between 1.0 μm and 1.6 μm, because silicon photodetectors are not sensitive to radiation within this wavelength region and germanium APDs are noisy.

Considerable interest has therefore been directed toward fabricating avalanche photodetectors using Group III-V compound semiconductors, such as $Ga_{0.47}In_{0.53}As$, as the light absorbing material which is grown lattice matched to a substrate comprising a Group III-V semiconductor such as InP. $Ga_{0.47}In_{0.53}As$ is a desirable material for optical communications systems because it is sensitive to, i.e., absorbs, radiation having wavelengths less than 1.7 μm, i.e., wavelengths within the region between 1.0 μm and 1.6 μm. However, it was early realized that it was difficult to achieve the desired operating characteristics in avalanche photodetectors using this material in structures that were analogous to previously developed silicon structures because the dark currents were so large that it was impossible to obtain the desired avalanche gain. It is presently believed that the dark current at a high electric field, i.e., $10^5 V/cm$ or greater, is at least partially due to a tunneling current which increases as the energy bandgap decreases. That is, the small bandgap which is advantageous as it enables the $Ga_{0.47}In_{0.53}As$ to absorb long wavelength radiation is also disadvantageous as it leads to an increased dark current in avalanche photodetectors. The dark current is also large in $Ga_{0.47}In_{0.53}As$ because of the small electron effective mass.

Accordingly, various structures using $Ga_{0.47}In_{0.53}As$ as the absorbing material have been proposed in attempts to reduce the dark current in avalanche photodetectors. One such structure is described in Japanese Journal of Applied Physics, 19, pp. L277-L280, June 1980. The structure described had a high bandgap InP region having a $p^{+}$-n junction and a low bandgap n-type $Ga_{0.47}In_{0.53}As$ region. The light was absorbed in the low bandgap material, and the resulting photogenerated carriers avalanched in a portion of the high bandgap region near the $p^{+}$-n junction. The tunneling current was reduced, with respect to an all $Ga_{0.47}In_{0.53}As$ device, because the avalanche process took place in a portion of the high bandgap region spaced from the heterointerface, and the electric field at the heterojunction was thus less than the field in the avalanche region and lower than the typical field required for tunneling in $Ga_{0.47}In_{0.53}As$. The device thus has separate absorption and multiplication regions and is commonly referred to as a SAM, which is an acronym for Separate Absorption and Multiplication regions. A more detailed study of this device, which also attempts to reduce the dark current, is described by Susa et al in IEEE Journal of Quantum Electronics, QE-16, pp. 864-869, August 1980. The device described also has an n-type $Ga_{0.47}In_{0.53}As$ absorbing region and a $p^{+}$-n InP junction separated from the heterojunction.

Still another SAM photodetector is described and discussed in Applied Physics Letters, 39, pp. 402-404, September 1, 1981. The structure described is superficially similar to that of Susa et al, but the analysis presented of the desired device parameters is precise. For a $Ga_{0.47}In_{0.53}As$/InP device, appreciable tunneling occurs at the heterojunction at breakdown unless $E_i$, that is, the interface electric field, is less than a critical value which is $1.5 \times 10^5 v/cm$ for $Ga_{0.47}In_{0.53}As$.

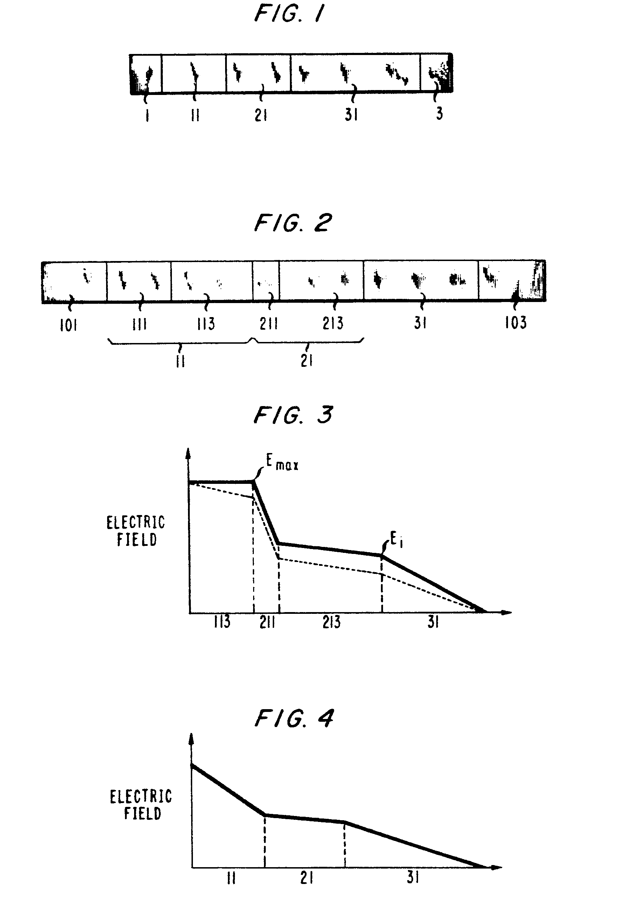

As is evident from their FIG. 2 and the discussion of this Figure, $\sigma_T$, which is the total charge per unit area swept out in the $Ga_{0.47}In_{0.53}As$ region, must be less than $10^{12}cm^{-2}$ to prevent tunneling. However, the maximum electric field, $E_m$, in the n-type InP region must be large enough, at least $4.5 \times 10^5 V/cm$, for the desired avalanche gain to occur. Reference to their FIG. 2 also shows that $\sigma_B$, the charge density per unit area depleted in the n-type InP region, must be at least $2 \times 10^{12}cm^{-2}$. However, if $\sigma_B$ is too large, i.e. greater than $3 \times 10^{12}cm^{-2}$, the InP is not completely depleted at breakdown and the photodetector has low quantum efficiency. The device design can be described more precisely by the equation

$$E_m = e\left(\frac{\sigma_T}{\varepsilon_T} + \frac{\sigma_B}{\varepsilon_B}\right) \tag{1}$$

where $e$, $\varepsilon_T$, and $\varepsilon_B$ are the electron charge and the permittivities of the binary and ternary materials, respectively. Further

$$E_i = e\sigma_T/\varepsilon_T. \tag{2}$$

It is now apparent to those skilled in the art that this is a good device but that the design and fabrication are critical because only a small range of charge densities, $\sigma_B$ and $\sigma_T$ yield both high quantum efficiency and low tunneling current. Additionally, these constraints also make it difficult to achieve high gain and low tunneling dark current simultaneously.

According to this invention an electronic device includes a low bandgap region, a high bandgap region, the low bandgap region and the high bandgap region having a common interface, and first and second electrical contacts to the high bandgap region and to the low bandgap region, respectively, the high bandgap region including a first region having an electric field such that the avalanche gain is greater than 1.0 under appropriate bias conditions and a first electric field gradient, and a second region having an electric field less than the breakdown field under appropriate bias conditions and a second electric field gradient, the first region being spaced from the interface of the high bandgap region and the low bandgap region by the second region.

We have found that high gain and quantum efficiency together with low dark current may be obtained in an avalanche photodetector embodying the invention. Under appropriate bias conditions, the second region's electric field is such that the avalanche gain is greater than 1.0 and greater than the first region's electric field. In one embodiment, the second region is more heavily doped than the first region. In another embodiment, the first region is more heavily doped than the second region. In a particular embodiment, the second region comprises a very lightly doped, either $\upsilon$ or $\pi$ conductivity, region and there is a transition region which comprises a thin heavily doped region between the first and second regions. The heavily doped transition region is spaced from the interface between the high bandgap and the low bandgap regions by a lightly doped, either conductivity type, region which forms the first region. In a still further embodiment, the high bandgap region comprises $Al_{0.48}In_{0.52}As$ or InP and the low bandgap region comprises $Ga_{0.47}In_{0.53}As$. The incident radiation is absorbed in the low bandgaop region and avalanche multiplication occurs in that portion of the high bandgap region where the field is of the order of the breakdown field.

The invention will now be described by way of example with reference to the accompanying drawings, in which:

FIG. 1 is a schematic representation of an avalanche photodetector embodying the invention;

FIG. 2 is a schematic representation of another photodetector embodying the invention;

FIG. 3 is a plot of the electric field for the regions of the device depicted in FIG. 2;

FIG. 4 is a plot of the electric field for the regions of a device embodying the invention;

FIG. 5 is a sectional view of a device embodying the invention; and

FIG. 6 is a sectional view of another device embodying the invention.

For reasons of clarity, the elements of the device are not drawn to scale in the Figures.

An exemplary device schematically depicted in section in FIG. 1 comprises a first high bandgap region 11 which has, under appropriate bias conditions, a first electric field such that the avalanche gain is greater than 1.0, a second high bandgap region 21 which has a second electric field which is less than the breakdown field and the first electric field, and a low bandgap region 31. The first and second high bandgap regions have first and second electric field gradients, respectively. In one embodiment, region 11 is more heavily doped than is region 21. In another embodiment, region 21 is more heavily doped than is region 11. The first region 11, which has the higher electric field, is spaced from the interface of regions 21 and 31. The device further comprises regions 1 and 3 which form electrical contacts to regions 11 and 31, respectively. Region 1 may comprise a metal or a metal and a heavily doped region. Region 3 comprises a metal and a heavily doped region. The low bandgap region 31 is an absorption region and the high bandgap regions 11 and 21 form the multiplication region, although, as will be readily appreciated by those skilled in the art, avalanche gain occurs in only a portion of these regions. It is to be understood for both this and other embodiments that the terms "electric field", "electric field gradient", and "bandgap" refer to average values within each region as the regions may have, for example, compositional or doping nonuniformities, which result in nonuniform bandgaps or electric fields within the regions.

It will be readily appreciated from the explanation and discussion that follow that devices embodying the        invention may have a low value of the interface electric field, thereby reducing the tunneling current. The avalanche region, i.e., the region in which avalanche gain occurs, may be relatively thick as the electric field in the high field may be nearly constant, i.e., it has a small gradient, and is certainly significantly smaller than in the avalanche region of a conventional SAM APD. The total gain is relatively large, but it is not obtained at the expense of a large interface field; thus, the dark current may be minimized. In addition, the lower electric field in the avalanche region reduces the excess noise factor.

These attributes will be better understood by consideration of the embodiment depicted in FIG. 2. The device depicted comprises regions 101, which is a metal. and 103, which has a highly doped region and a metal. Region 111 is highly doped and has a conductivity type opposite that of region 103. Region 111 may be omitted for a Schottky barrier device. Regions 101 and 111 form a first electrical contact region and region 103 forms a second electrical contact region. Between the two contact regions 101 and 103, there are regions 11, 21, and 31. Regions 21 and 31 contact each other, i.e., they have an interface. The high bandgap region comprises region 111 which is highly doped and has a first conductivity type. region 113 which is of intrinsic, $\nu$ or $\eta$, conductivity, region 211 which is heavily doped and of a second conductivity type, and region 213 which has intrinsic conductivity. Region 213 is desirable to avoid having a heavily doped region at the interface. Regions 113, 211, and 213 are the first , transition, and second regions, respectively. Region 211 has a thickness $\Delta x$ and is spaced from the interface of regions 21 and 31. Region 31 has a low bandgap and a second conductivity type and is preferably intrinsic. The term "intrinsic conductivity" means that the regions are not intentionally, or are very lightly, doped and typically have a dopant concentration less than $10^{15} cm^{-3}$,

i.e., they are either $\nu$ or $\pi$.

Typical ranges of the parameters, such as layer thickness and doping concentration, are as follows. Region 111 typically has a doping concentration typically between $10^{18}$ and $10^{19}$ $cm^{-3}$ and a thickness between 1 and 2 $\mu m$. Region 113 has intrinsic conductivity, that is, the doping concentration should be less than $10^{15}$ $cm^{-3}$ and has a thickness between 100 nm and several $\mu m$. Region 211 has a doping concentration typically between $10^{16}$ $cm^{-3}$ and $5 \times 10^{18}$ $cm^{-3}$ and a thickness that is typically between 5 and 500 nm. Region 213 has values for the doping that are generally the same as region 113, although it is in general much thinner, for example, as thin as 10 nm, and this region should also preferably be punched through under avalanche conditions. Region 31 has a doping concentration between $5 \times 10^{14}$ and $5 \times 10^{16}$ $cm^{-3}$. Region 31 may be punched through. However, punchthrough should occur before the onset of sizable gain. Regions 113, 213, and 31 need not have intrinsic conductivity. However, if they are doped, the doping concentration should preferably be less than that of region 211, and these regions should also be preferably punched through under avalanche conditions.

The conductivity types of the regions depend upon the relative values of $\alpha$ and $\beta$, i.e., the ionization coefficients for electrons and holes, respectively. That is, the conductivity types should be selected so that the carrier having the higher ionization coefficient initiates the avalanche process. For high bandgap InP and low bandgap $Ga_{0.47}In_{0.53}As$, appropriate conductivity types are: $111-p^+$; $113-\nu$ or $n^-$; $211-n^+$; $213-\nu$ or $n^-$; $31-\nu$ or $n^-$; and $103-n^+$. For other materials systems, such as Si/Ge, all of these conductivity types should be reversed.

Devices embodying the invention may be grown with conventional and well-known growth techniques, such as vapor phase epitaxy, molecular beam epitaxy, or a metallo-organic chemical vapor deposition. Regions 111, 113, 211, and 213 may comprise, for example, $Al_{0.48}In_{0.52}As$, and region 31 may comprise, for example, $Ga_{0.47}In_{0.53}As$. Of course, other Group III-V or Group II-VI compound semiconductors, as well as Si and Ge, may be used. The electrical contacts are formed by using conventional techniques that are well known to those skilled in the art.

The operation of a device embodying the invention and the selection of appropriate device parameters may be better understood by reference to FIG. 3 which shows the electric field in the several regions of the device depicted in FIG. 2 vertically in arbitrary units versus the distance along the axis of the device horizontally. The electric field indicated by the solid line is the idealized electric field and the dashed line indicates the electric field that is more likely to be realized. As can be seen, the electric field decreases rapidly in transition region 211 from its maximum value, $E_{max}$, to a value close to the value of the interface field value, $E_i$. It can also be that the maximum electric field region can be maintained over a wide region.

The structure described may be termed a "high-low SAM," and it has several desirable attributes. For example, a significantly lower electric field, $E_a$, is required in the avalanche region than in a conventional SAM because the avalanche process can occur over a wider region. In an InP avalanche region, the field can be reduced by a factor of 2 with respect to the peak electric field of a conventional SAM APD, and the desired high gain is obtained by using a relatively thick avalanche region. The selection of a low $E_a$ enables the value of the interface field, $E_i$, to be significantly lower than the tunneling field, $E_{it}$ and less to a lower excess avalanche noise factor than is present in a conventional SAM APD.

The precise choice of parameters for the embodiment depicted in FIG. 3, with region 213 having intrinsic conductivity, will be better understood from the following considerations. Selection of the desired ionization rates ratio, $K = \beta/\alpha$, determines the electric field, $E_1$. If it is now assumed that at this field the avalanche gain is high, the ionization integral may be set equal to 1.0 and the width of the avalanche region, i.e., region 113, determined. See, for example, Physics of Semiconductor Devices, 2nd Edition, S. M. Sze, pp. 99-108, 1981. John Wiley & Sons, Inc. If the electric field, $E_2$, on the low bandgap side of region 211 is now fixed, use of Poisson's equation enables the charge sheet density, $\sigma_{sp}$, to be determined. Of course, $E_2$ should be smaller than the electric field required for tunneling in the absorption region. The charge density is the product of the charge, $N_T$, and the layer thickness. Those skilled in the art may now verify that the electric field at punchthrough in the avalanche region is less than the breakdown field.

Example:

The device comprises $InP/Ga_{0.47}In_{0.53}As$ regions. Under operating conditions, $E_2$ is $1 \times 10^5 V/cm$, and $E_1$ is $4 \times 10^5 V/cm$. The width of the avalanche region is 1.7 μm and its doping is preferably lower than $10^{15} cm^{-3}$. The value of $K = \beta/\alpha$ is 8291/3985 or 2.08. The charge density is $2.2 \times 10^{12} cm^{-2}$. This density may be obtained with a doping concentration of approximately $5 \times 10^{17} cm^{-3}$, within region 211, and a width of approximately 44 nm. The thickness of the absorption region, i.e., region 31, is 2 μm and the doping is typically between $5 \times 10^{14} cm^{-3}$ and $2 \times 10^{15}$. The thickness is determined by the absorption coefficient and the doping should be low to allow punchthrough of the region before the onset of gain and to permit an interface field less than the tunneling field before punchthrough. The thickness of region 213 is not generally critical and is typically between 20 and 300 nm.

A portion of region 31 adjacent to the interface with region 213 may have a graded bandgap or a bandgap between that of region 213 and the remainder of region 31 to reduce carrier trapping at the interface. A typical material for this portion is InGaAsP of varying composition over a distance of 50 to 200 nm.

Additional desirable attributes are also evident from FIG. 3. For example, a wide range of electric fields in region 113 may be obtained by simply changing the position and doping concentration of region 211. The ability to use a relatively low electric field in the avalanche gain region arises from the fact that the electric field is constant, rather than linearly decreasing as in prior art SAMs. Gain stability against voltage fluctuations is also increased when the low gap layer is punched through before the onset of gain.

The electric fields in regions 11, 21, and 31 are depicted in FIG. 4 of yet another embodiment with the electric field plotted vertically in arbitrary units. The gradients depicted are exemplary and may be modified by those skilled in the art. For example, although region 11 is depicted as having a larger gradient than region 21, devices embodying the invention may be fabricated with region 21 having the larger gradient.

Examples:

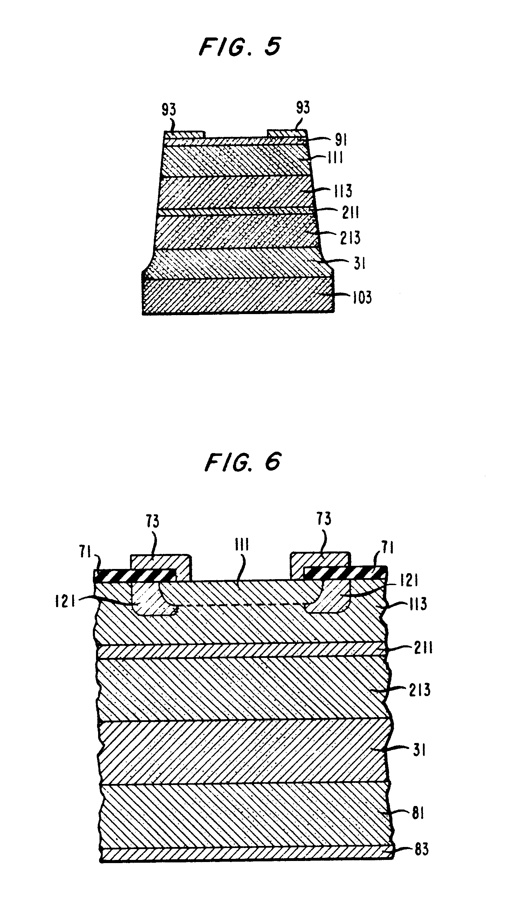

Gains greater than 60 were obtained with a voltage of 25 volts and a dark current less than $10^{-9}$ Amp at unity gain before the onset of multiplication in an $Al_{0.48}In_{0.52}As/Ga_{0.53}In_{0.47}As$ device depicted in a sectional view in FIG. 5. The device comprises a $p^+-Al_{0.48}In_{0.52}As$ layer 111 which is 1 to 2 μm thick and a doping concentration between $10^{18}$ and $10^{19} cm^{-3}$; a $v-Al_{0.48}In_{0.52}As$

layer 113 which is 500 nm thick; a $n^+$-$Al_{0.48}In_{0.52}As$ layer 211 which has a $5 \times 10^{17} cm^3$ doping concentration and is 50 nm thick; a $\nu$-$Al_{0.48}In_{0.52}As$ layer 213 which is 300 nm thick; a $Ga_{0.47}In_{0.53}As$ layer 31 which has a $5 \times 10^{15}$ doping concentration and has a 1-2 $\mu m$ thickness; and an $n^+$ layer or substrate 103 which has a $5 \times 10^{18} cm^{-3}$ doping concentration. The preferred dopant for layer 211 is Si. The device also comprises layer 91 which is highly doped $In_{0.53}Ga_{0.47}As$ and is contacted by metallization 93, such as alloyed Au/Be and evaporated Ti.

In addition to the mesa structure depicted in FIG. 5, planar embodiments, such as that depicted in FIG. 6, are also contemplated. The device comprises region 111 which is $p^+$ Cd-doped by diffusion, $10^{18}$-$10^{19} cm^{-3}$, InP; region 113 which is $\nu$-InP; region 211 which is $n^+$ Si-doped, $10^{17}$-$10^{19} cm^{-3}$ and, typically, 5 to 500 nm thick, InP; region 213 which is $\nu$-type InP and is between 10 and 100 nm thick; and region 31 which is $n^+$ or $\nu$ InGaAs and approximately 2 $\mu m$ thick. The regions are disposed over $n^+$ buffer layer and substrate 81 which is contacted by metallization 83. Guard ring 121 has a conductivity type opposite to that of region 111. Region 111 is contacted by metallization 73 which is separated from region 113 by insulator 71. Metallization 73 is conventional, e.g., Au/Be and Ti, and insulator 73 is conventional, such as $Si_3N_4$.

Modifications will be readily thought of by those skilled in the art. For example, region 213 may be omitted. Furthermore, the avalanche region 11 as well as region 31 may have one or more graded bandgap layers, a quantum well structure, or superlattice structure, etc. The superlattice structure may have a constant or varying period. It will be readily appreciated that if graded bandgap layers are present in the absorption region, they are compositionally graded so that the high bandgap portion of region 31 is adjacent region 21. The graded region comprises, in one embodiment, a first plurality of layers of a first compound semiconductor interleaved with a second plurality of a second compound semiconductor. The average composition of a series of epitaxial layers is equal to the desired graded composition. It will be readily appreciated that the compositions of the first and second pluralities change to accomplish the grading. Continuous grading may also be used. These embodiments are useful when charge trapping at the interface of regions 21 and 31 limits device speed.

It will be readily appreciated by those skilled in the art that devices embodying the invention may be used as IMPATT diodes with the low bandgap region being the drift region and the high bandgap region being the avalanche region.

- 14 -  0150564

CLAIMS

1.  An electronic device including a low bandgap region (31), a high bandgap region (11,21), the low bandgap region and the high bandgap region having a common interface, and first (1) and second (3) electrical contacts to the high bandgap region and to the low bandgap region, respectively, CHARACTERIZED IN THAT the high bandgap region includes a first region (11) having an electric field such that the avalanche gain is greater than 1.0 under appropriate bias conditions and a first electric field gradient, and a second region (21) having an electric field less than the breakdown field under appropriate bias conditions and a second electric field gradient, the first region being spaced from the interface of the high bandgap region and the low bandgap region by the second region.

2.  A device as claimed in claim 1, wherein the first region includes a region (113) of intrinsic conductivity adjacent the first electrical contact.

3.  A device as claimed in claim 1 or 2, wherein the second region includes a region (213) of intrinsic conductivity, adjacent the interface region.

4.  A device as claimed in claim 1, 2 or 3 including a heavily doped transition region (211) having a first conductivity type between the first and second regions.

5.  A device as claimed in claim 4, wherein the heavily doped transition region has a doping concentration between $1 \times 10^{16} cm^{-3}$ and $5 \times 10^{18} cm^{-3}$.

6.  A device as claimed in claim 4 or 5, wherein the heavily doped transition region has a thickness between 5 and 500 nm.

7.  A device as claimed in claim 4, 5 or 6, wherein when the first conductivity type is n-type, the regions include materials selected from Group III-V and Group II-VI compound semiconductors, and when the first conductivity type is p-type, the regions include materials selected from Si, Ge compounds thereof, and AlInGaAs.

8.  A device as claimed in claim 1, wherein the second region is more heavily doped than the first region.

9.  A device as claimed in claim 1, wherein the first region is more heavily doped than the second region.

10.  A device as claimed in claim 1 wherein the low bandgap region includes a region of varying bandgap, the high bandgap portion of that region being adjacent the second region.

11.  A device as claimed in claim 10, wherein the varying bandgap region includes a superlattice structure.

12.  A device as claimed in claim 11, wherein the superlattice structure includes a first plurality of layers of a first compound semiconductor interleaved with a second plurality of a second compound semiconductor.

CSTB/KW

*FIG. 1*

*FIG. 2*

*FIG. 3*

ELECTRIC FIELD

$E_{max}$

$E_i$

*FIG. 4*

ELECTRIC FIELD

FIG. 5

FIG. 6